Europäisches Patentamt

European Patent Office

Office européen des brevets

(19)

(11) Veröffentlichungsnummer: **0 161 325**
**A1**

(12) # EUROPÄISCHE PATENTANMELDUNG

(21) Anmeldenummer: 84105478.6

(22) Anmeldetag: 15.05.84

(51) Int. Cl.⁴: **H 03 D 3/00**

(43) Veröffentlichungstag der Anmeldung: 21.11.85
Patentblatt 85/47

(84) Benannte Vertragsstaaten: **DE FR GB IT NL**

(71) Anmelder: **Deutsche ITT Industries GmbH,
Hans-Bunte-Strasse 19 Postfach 840, D-7800 Freiburg
(DE)**

(72) Erfinder: **Mehrgardt, Söhnke, Dr., Häglestrasse 26,
D-7801 March-Neuershausen (DE)**

(74) Vertreter: **Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)**

(54) Digitaler Frequenz-Demodulator für ein Digitalsignal.

(57) Das mittels des vom Taktsignal (f) getakteten Analog-Digital-Wandlers (aw) aus dem Analogsignal (al) gebildete Digitalsignal (x) ist dem Verzögerungsglied (v1) und dem 90°-Phasenschieber (ht) gleichzeitig zugeführt. Das verzögerte Digitalsignal (x') ist über das weitere Verzögerungsglied (v2) und auch direkt jeweils einem Eingang des Multiplizierers (m1) zugeführt. In gleicher Weise ist das Signal (y) am Ausgang des 90°-Phasenschiebers (ht) einmal direkt und einmal über das weitere Verzögerungsglied (v3) jeweils einem Eingang des Multiplizierers (m2) zugeführt. Die Ausgangssignale der Multiplizierer (m1, m2) sind mittels des Addierers (ad) zur Lieferung des demodulierten Digitalsignals (ds) addiert. Dadurch können mehrfache Multiplikationen und auch eine Mischung zur Bildung des hilbert-transformierten Signals (y) entsprechend dem bekannten Stand der Technik vermieden werden.

S.Mehrgardt 1

Fl 1219 EP
Mo/bk
09. Mai 1984

Digitaler Frequenz-Demodulator für ein Digitalsignal

Die Erfindung betrifft einen digitalen Frequenz-Demodulator, der einen digitalen 90°-Phasenschieber (= Hilbert-Transformator = Quadratursignal-Generator) für das zu demodulierende, aus einem Analogsignal mittels eines von einem Taktsignal getakteten Analog-Digital-Wandlers gebildete Digitalsignal, Verzögerungsglieder, die eine Verzögerungszeit gleich der Periodendauer des Taktsignals haben, einen Addierer und Multiplizierer enthält.

Ein derartiger digitaler Frequenz-Demodulator ist in der Offenlegungsschrift DE 28 33 335 A1, die der veröffentlichten Patentanmeldung GB 20 27 297 A entspricht, beschrieben. Nach dem Hauptgedanken der vorbeschriebenen Anordnung wird die Demodulation dadurch erreicht, daß die Differenz zweier mit einem Abtastsignal gebildeter benachbarter Momentanphasenwerte ausgewertet wird. Dabei spielt eine wesentliche Rolle, daß das demodulierte Signal, in den vorbeschriebenen Unterlagen als Frequenzwort bezeichnet, mindestens ein dreistelliges Signal ist. Die benachbarten Momentanphasenwerte des zu demodulierenden Signals werden dabei mittels eines Hilbert-Transformators gebildet, und die weitere Verarbeitung geschieht zusätzlich zu den im Oberbegriff des Anspruchs 1 angegebenen Teilschaltungen noch mit in mathematischem Sinn den Betrag der Signale bildenden Stufen, einer Schwellwertlogik, einem Umpoler und mehreren exklusiven ODER-Gattern sowie mehreren Paritäts-Prüfschaltungen.

- 2 -

S.Mehrgardt 1                                    Fl 1219 EP

Ausgehend von den im Oberbegriff des Anspruchs 1 angegebenen Teilschaltungen der vorbeschriebenen Anordnung besteht die Aufgabe der in den Ansprüchen angegebenen Erfindung darin, einen demgegenüber nach anderen digitalen Schaltungsprinzipien arbeitenden digitalen Frequenz-Demodulator anzugeben, der außerdem insofern einfacher realisiert ist, als auf logische Signalverknüpfungen, wie sie bei der bekannten Anordnung in Form der exklusiven ODER-Gatter vorhanden sind, verzichtet wird. Ferner sollen die bei der vorbeschriebenen Anordnung für mehr als dreistellige Frequenzworte erforderlichen Mehrfachmultiplikationen vermieden werden (für ein z.B. sechsstelliges Frequenzwort, was die Untergrenze für das zu fordernde Auflösungsvermögen der Analog-Digital-Wandlung sein dürfte, sind bei der vorbeschriebenen Anordnung sieben Multiplikationen und für ein achtstelliges Frequenzwort schon 31 Multiplikationen erforderlich).

Bei der Lösung der gestellten Aufgabe greift die Erfindung auf die Anordnung nach der Offenlegungsschrift DE 31 38 464 A1 zurück, die rein formal der Erfindung näherzustehen scheint, jedoch aufgrund der dort vorgeschriebenen Mischung des Digitalsignals einerseits mit einer Impulsfolge aus positiven und negativen Einheitsimpulsen und andererseits mit einer dazu um 90° phasenverschobenen gleichartigen Impulsfolge, aus welcher Mischung die hilbert-transformierten Signale abgeleitet werden, und deren jeweiliger Tiefpaßfilterung sowie der Multiplizierung des verzögerten einen hilbert-transformierten Signals mit dem unverzögerten anderen hilbert-transformierten Signal ergibt sich eine von der Erfindung wesentlich abweichende Anordnung.

Die Erfindung wird nun anhand der Figuren der Zeichnung näher erläutert.

S.Mehrgardt 1                                    Fl 1219 EP

Fig. 1    zeigt schematisch als Blockschaltbild ein all-
          gemeines Ausführungsbeispiel der Erfindung,

Fig. 2    zeigt wiederum als schematisches Blockschaltbild ein bevorzugtes Ausführungsbeispiel der
          Erfindung,

Fig. 3    zeigt als Blockschaltbild eine Weiterbildung der
          Anordnung nach Fig. 2, und

Fig. 4    zeigt eine weitere Weiterbildung der Anordnung
          nach Fig. 2.

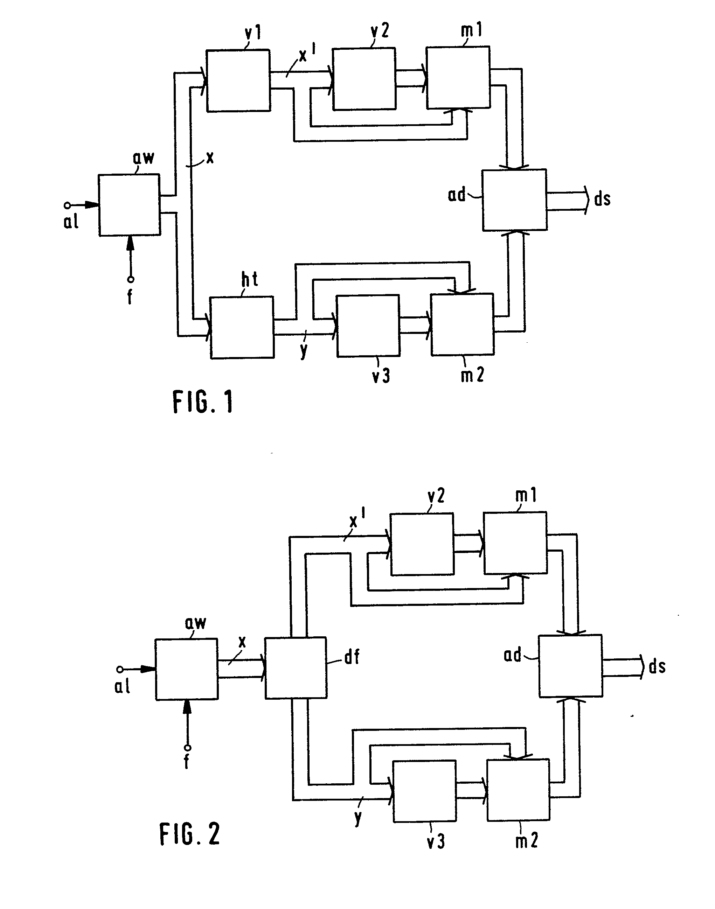

Das allgemeine Ausführungsbeispiel entsprechend dem
schematischen Blockschaltbild der Fig. 1 zeigt in
Richtung des Signalflusses zunächst den Analog-Digital-
Wandler aw, dessen Analog-Eingang das Analog-Signal al,
das selbstverständlich ein entsprechend frequenzmoduliertes Signal ist, und dessen Takteingang das Taktsignal f
zugeführt ist. Das Ausgangssignal des Analog-Digital-
Wandlers aw ist das Digitalsignal x, das im allgemeinen
als paralleles Digitalsignal vorliegen wird, d.h. als
mehrstelliges Digitalwort.

Das Digitalsignal x ist einerseits dem digitalen 90°-
Phasenschieber ht und andererseits dem ersten Verzögerungsglied v1 zugeführt, dessen Verzögerungszeit gleich der
des 90°-Phasenschiebers ht ist. Dieser wird in der Fachwelt auch als Hilbert-Transformator oder Quadratursignal-
Generator bezeichnet. Bei der oben erwähnten Anordnung
nach der Offenlegungsschrift DE 31 38 464 A1 werden durch
die erwähnte Mischung mit den beiden um 90° phasenversetzten Impulsfolgen ebenfalls hilbert-transformierte
Signale erzeugt. Der Unterschied zur vorliegenden Erfindung besteht jedoch darin, daß nach der Erfindung das
Digitalsignal x als entsprechend verzögertes Digitalsignal x' ohne Beeinflussung durch einen Mischungsvorgang weiterverarbeitet wird und daß auch das hilbert-
transformierte Signal y nicht durch Mischung erzeugt

- 4 -

zu werden braucht.

Das verzögerte Digitalsignal x' ist, über das zweite Verzögerungsglied v2 geführt, dem einen Eingang des ersten Multiplizierers m1 zugeführt und in entsprechender Weise das hilbert-transformierte Signal y, über das dritte Verzögerungsglied v3 geführt, dem ersten Eingang des zweiten Multiplizierers m2. Die jeweiligen Verzögerungszeiten t der beiden Verzögerungsglieder v2, v3 sind einander gleich und gleich der Periodendauer des Taktsignals f.

Das verzögerte Digitalsignal x' ist dem zweiten Eingang des ersten Multiplizierers m1 und das hilbert-transformierte Signal y dem zweiten Eingang des zweiten Multiplizierers m2 zugeführt. Bei der Erfindung liegt somit keine Über-Kreuz-Zuführung der Signale zu den beiden Multiplizierern vor, wie sie bei der Anordnung nach der DE 31 38 464 A1 vorgesehen ist. Die Ausgangssignale der beiden Multiplizierer m1, m2 werden schließlich mittels des Addierers ad addiert, an dessen Ausgang bereits das demodulierte Signal ds auftritt.

Beim bevorzugten Ausführungsbeispiel nach Fig. 2 sind der 90°-Phasenschieber ht und das erste Verzögerungsglied v1 zum nichtrekursiven Digitalfilter df ungeraden Grades zusammengefaßt, an dessen einem Ausgang das verzögerte Digitalsignal x' und an dessen anderem Ausgang das hilbert-transformierte Signal y auftritt. Die weitere Verarbeitung dieser beiden Signale ist identisch mit der Verarbeitung nach Fig. 1.

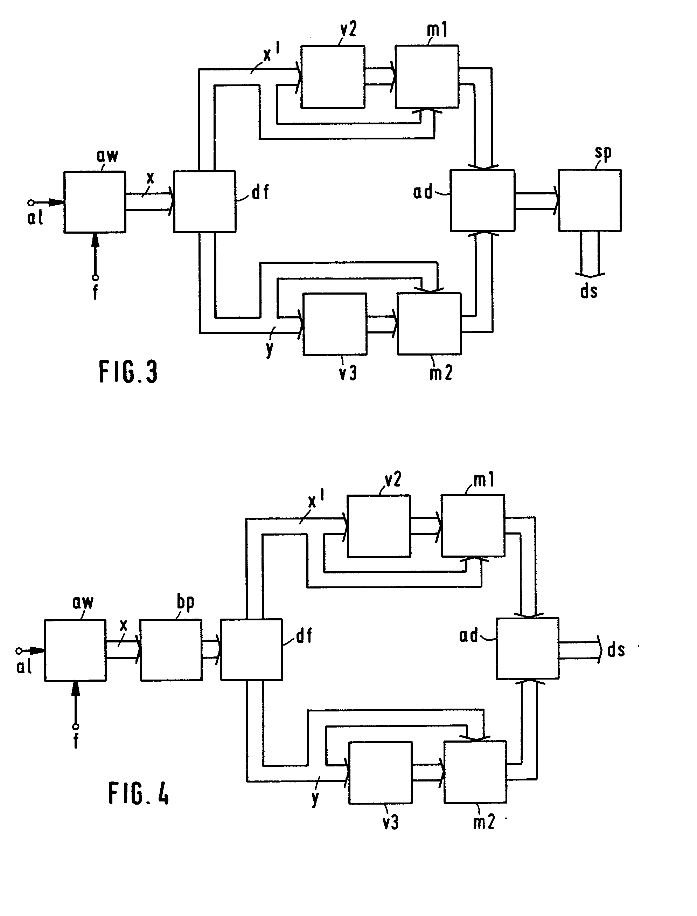

In Fig. 3 ist eine Weiterbildung der Anordnung nach Fig. 2 gezeigt, die ebenfalls bei der Anordnung nach Fig. 1 vorgesehen werden kann. Die Weiterbildung besteht in der Anordnung des die Arcus-Sinus-Funktion enthaltenden

- 5 -

S.Mehrgardt 1                                    Fl 1219 EP

elektronischen Speichers sp am Ausgang des Addierers ad,
so daß das demodulierte Signal ds am Ausgang des
Speichers sp auftritt. Ein derartiger Arcus-Sinus-
Speicher ist an sich aus der letztgenannten Offenlegungsschrift bekannt.

Die Fig. 4 zeigt eine andere Weiterbildung der Anordnung
nach Fig. 2 die ebenfalls bei der Anordnung nach Fig. 1,
aber auch bei der nach Fig. 3 vorgesehen werden kann.
Sie besteht darin, daß das Digitalsignal x, bevor es
den weiteren Teilschaltungen zugeführt wird, einer digitalen Bandbegrenzung unterzogen wird, daß also dem Ausgang des Digital-Analog-Wandlers der digitale Bandpaß bp
direkt nachgeschaltet ist. Dieser Bandpaß unterdrückt außerhalb des frequenzmodulierten Nutzsignals liegende Störsignale.
Nach einer Weiterbildung der Erfindung kann dieses Bandpaß bp
eine Stufe zur Dezimierung der Taktfrequenz $f_t$ enthalten. Bei
Dezimierung der Taktfrequenz um den ganzzahligen Faktor N
auf $f_d = f_t/N$ muß der Durchlaßbereich des Bandpasses in einem
der Frequenzbänder zwischen $nf_d/2$ und $(n+1)f_d/2$ liegen,
wobei n ganzzahlig ist und zwischen 0 und N-1 liegt.

Die oben erwähnte Weiterbildung der Erfindung mit dem
die Arcus-Sinus-Funktion enthaltenden elektronischen
Speicher sp läßt sich dann ohne unvertretbar großen Aufwand realisieren, wenn die Stellenzahl des Digitalsignals
x bei etwa 6 bis 8 liegt, was für übliche Videosignal-
Verarbeitung ausreicht. Für die Verarbeitung von Audiosignalen dagegen, die eine Stellenzahl des Digitalsignals x von etwa 15 erfordert, würde ein derartiger
Speicher in integrierter Form jedoch eine Chip-Fläche
erfordern, die nach den derzeitigen Möglichkeiten der
Halbleitertechnik nur mit unvertretbar großem Aufwand zu
realisieren ist. Für die Frequenzdemodulation von Audiosignalen sind derzeit daher die Ausführungsbeispiele nach den

S.Mehrgardt 1                                    Fl 1219 EP

Figuren 1, 2 und 4 zu bevorzugen.

Die Erfindung setzt voraus, daß, wie dies bei der analogen Frequenzdemodulation im allgemeinen üblich ist, daß
das zu demodulierende Analogsignal al vor dem Analog-
Digital-Wandler aw einer Amplitudenbegrenzung unterworfen
wird, um dem frequenzmodulierten Signal überlagerte
Amplitudenmodulation von vorneherein zu unterdrücken.
Sollte dies jedoch nicht möglich sein oder angebracht
erscheinen, so kann bei der Erfindung die Begrenzung auch
auf der digitalen Seite vorgenommen werden, etwa mittels
eines digitalen Amplitudenbegrenzers am Ausgang des
Digital-Analog-Wandlers aw oder mittels einer Amplitudenkorrekturstufe, der das demodulierte Ausgangssignal ds
zugeführt ist. Auch eine automatische Verstärkungsregelung auf der analogen oder digitalen Signalseite ist
möglich.

Die Erfindung läßt sich ohne weiteres mittels integrierter Schaltungen realisieren bzw. kann für sich oder
als Teil einer integrierten Schaltung verwirklicht werden. Bei dieser Realisierung ist insbesondere das bevorzugte Ausführungsbeispiel nach Fig. 2 von Vorteil,denn
das dort und bei dessen Weiterbildungen vorgesehene nichtrekursive Digitalfilter df ungeraden Grades weist die folgenden
günstigen Eigenschaften auf.     Die Gruppenlaufzeit ist
ein ganzzahliges Vielfaches der Periodendauer des Taktsignals f, die Impulsantwort ist antisymmetrisch, jeder
zweite Wert der Impulsantwort ist gleich null,
und die Phasenverschiebung zwischen Eingangs- und Ausgangssignal ist exakt                     gleich 90°. So
hat beispielsweise ein derartiges, für einen digitalen
Frequenzdemodulator für Video-FM-Signale entworfenes Filter des
Grades 15 mit einer Bandbreite von 0,08 - 0,42 $f_t$ (das entspricht
bei $f_t$ = 17,8 MHz einer Bandbreite von 1,42 bis 7,48 MHz)

S.Mehrgardt 1                              Fl 1219 EP

eine Amplitudenabweichung im Nutzband von kleiner 1%, und das Filter selbst benötigt lediglich 9 Additionen und 4 Subtraktionen, so daß der Flächenaufwand auf dem Halbleiter-chip vergleichsweise gering ist.

- 8 -

S.Mehrgardt 1

Fl 1219 EP
Mo/bk
09. Mai 1984

Patentansprüche

1. Digitaler Frequenz-Demodulator, der einen digitalen 90°-Phasenschieber ( = Hilbert-Transformator = Quadratursignal-Generator) (ht) für das zu demodulierende, aus einem Analogsignal (al) mittels eines von einem Taktsignal (f) getakteten Analog-Digital-Wandlers (aw) gebildete Digitalsignal (x), Verzögerungsglieder (v1, v2, v3), die eine Verzögerungszeit (t) gleich der Periodendauer des Taktsignals (f) haben, einen Addierer (ad) und Multiplizierer (m1, m2) enthält, gekennzeichnet durch folgende Merkmale:
   - ein erstes Verzögerungsglied (v1) liegt am Ausgang des Analog-Digital-Wandlers (aw), dessen Verzögerungszeit gleich der des 90°-Phasenschiebers (ht) ist,
   - am Ausgang des ersten Verzögerungsglieds (v1) liegt ein zweites Verzögerungsglied (v2), dessen Verzögerungszeit (t) gleich der Periodendauer des Taktsignals (f) ist,
   - am Ausgang des 90°-Phasenschiebers (ht) liegt ein drittes Verzögerungsglied (v3), dessen Verzögerungszeit gleich der des zweiten Verzögerungsglieds (v2) ist, und
   - am jeweiligen Ausgang des zweiten und des dritten Vezögerungsglieds (v2, v3) liegt jeweils der erste Eingang eines ersten bzw. eines zweiten Multiplizierers (m1, m2), dessen jeweiliger zweiter Eingang mit dem jeweiligen Eingang des zweiten bzw. des dritten Verzögerungsglieds (v2, v3) und dessen jeweiliger Ausgang mit jeweils einem Eingang des Addierers (ad) verbunden ist, an dessen Ausgang

0161325

- 9 -

S.Mehrgardt 1                                    Fl 1219 EP

das demodulierte Signal (ds) in digitaler Form abzunehmen ist.

2. Digitaler Frequenz-Demodulator nach Anspruch 1, dadurch gekennzeichnet, daß der 90°-Phasenschieber (ht)
und das erste Verzögerungsglied (v1) zu einem nichtrekursiven Digitalfilter (df) ungeraden Grades zusammengefaßt sind.

3. Digitaler Frequenz-Demodulator nach Anspruch 1 oder 2,
dadurch gekennzeichnet, daß der Ausgang des Addierers
(ad) am Eingang eines die Arcus-Sinus-Funktion enthaltenden elektronischen Speichers (sp) liegt, der
nunmehr den Ausgang für das demodulierte Signal (ds)
bildet.

4. Digitaler Frequenz-Demodulator, nach einem der Ansprüche 1 bis 3, dadurch gekennzeichnet, daß zwischen
dem Ausgang des Analog-Digital-Wandlers (aw) und
den Eingängen der direkt nachfolgenden Stufen ein
digitaler Bandpaß (bp) eingefügt ist, der das Digitalsignal (x) durchläßt  und Störkomponenten unterdrückt.

5. Digitaler Frequenz-Demodulator nach Anspruch 4, dadurch gekennzeichnet, daß der Bandpaß (bp) eine
Stufe zur Dezimierung der Taktfrequenz (t) um einen
ganzzahligen Faktor N enthält.

0161325

84 105478.6

1/2

FIG. 1

FIG. 2

FIG.3

FIG. 4

Europäisches Patentamt

# EUROPÄISCHER RECHERCHENBERICHT

Nummer der Anmeldung

EP 84 10 5478

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 080 014 (R. BOSCH)<br>* Figur 1; Seite 5, Zeilen 1-33 *<br>& DE-A-3 138 464 (Kat. D)<br><br>--- | 1,3 | H 03 D 3/00 |
| A | EP-A-0 035 166 (LICENTIA PATENT-VERWALTUNG)<br>* Figur 1; Referenz Nr. 3; Seite 6, Zeilen 3-16 *<br><br>--- | 2 | |
| D,A | DE-A-2 833 335 (LICENTIA PATENT-VERWALTUNG)<br>* Figure 5; Seite 6, Zeile 14 - Seite 7, Zeile 4 *<br><br>--- | | |
| A | PATENT ABSTRACTS OF JAPAN Band 6, No. 132, 17. Juli 1982, Seite (E-119) (1010); & JP-A-57-57007 (NIPPON DENSHIN DENWA KOSHA) 06-04-1982<br><br>--- | | RECHERCHIERTE SACHGEBIETE (Int. Cl.4)<br><br>H 03 D 3/00<br>H 04 L 27/14 |
| A | ELECTRONICS LETTERS Band 15, Nr. 16, 2 August 1979; F.G.A. COUPE "Digital frequency discriminator", Seiten 489-490<br>* Seite 490, Figur 3 *<br><br>----- | | |

Der vorliegende Recherchenbericht wurde für alle Patentansprüche erstellt.

| Recherchenort | Abschlußdatum der Recherche | Prüfer |
|---|---|---|
| BERLIN | 02-01-1985 | BREUSING J |